# EUROPEAN PATENT APPLICATION

(11) **EP 4 475 165 A1**
(43) Date of publication of application: **11.12.2024**
(21) Application number: 23746936.6
(22) Date of filing: 24.01.2023
(51) Int. Cl.: H01L 21/316, C23C 24/10

(54) **HAFNIUM COMPOUND-CONTAINING SOL-GEL LIQUID AND HAFNIA-CONTAINING FILM**

(30) Priority: 31.01.2022 JP 2022012867
(71) Applicant: Mitsubishi Materials Corporation, Tokyo 100-8117 (JP)
(72) Inventor: TSUJIUCHI, Naoto, Sanda-shi, Hyogo 669-1339 (JP)
(74) Representative: Hoffmann Eitle
(86) International application number: PCT/JP2023/002069
(87) International publication number: WO 2023/145725

(57) **Abstract**

A hafnium compound-containing sol-gel liquid contains an alcohol as a solvent and a hafnium compound as a hafnia source, in which the hafnium compound-containing sol-gel liquid contains one or two or more elements M selected from the group consisting of Zr, Ti, and Nb, a mass ratio W_{M}/W_{Hf} of a content W_{M} of the elements M to a content W_{Hf} of Hf as a metal component is within a range of 0.2% or more and 5.0% or less. A hafnia-containing film containing hafnia (HfO₂) and one or two or more elements M selected from the group consisting of Zr, Ti, and Nb, and in which a mass ratio W_{M}/W_{HfO2} of a content W_{M} of the elements M to a content W_{HfO2} of the HfO₂ is within a range of 0.05% or more and 5.0% or less.

## Description

### [Technical Field]

The present invention relates to a hafnium compound-containing sol-gel liquid used in the formation of a hafnia-containing film containing hafnia (also known as hafnium (IV) oxide, chemical formula: HfO₂) on a surface of a substrate, and a hafnia-containing film formed of the hafnium compound-containing sol-gel liquid.

Priority is claimed on Japanese Patent Application No. 2022-012867, filed January 31, 2022, the content of which is incorporated herein by reference.

### [Background Art]

In the related art, the above-mentioned hafnia-containing film is formed on surfaces of various substrates as a hard coat film with high hardness or an etching mask.

By forming the hafnia-containing film on the surface of the substrate in a patterned manner as an etching mask and performing an etching treatment on a surface of a substrate, a portion where the hafnia-containing film is formed remains without being etched, and a specific pattern is formed on the surface of the substrate.

As a method for forming the above-mentioned hafnia-containing film, for example, as described in Patent Documents 1 and 2, a method using a hafnium compound-containing sol-gel liquid containing a hafnium compound that serves as a hafnia source is proposed.

In Patent Documents 1 and 2, a hafnium compound-containing sol-gel liquid is applied onto a surface of a substrate, and a coated film of the hafnium compound-containing sol-gel liquid is subjected to a curing treatment to form a hafnia-containing film.

### [Citation List]

### [Patent Documents]

[Patent Document 1]
   Japanese Unexamined Patent Application, First Publication No. 2004-267822
[Patent Document 2]
   Japanese Unexamined Patent Application, First Publication No. 2002-187738

### [Summary of Invention]

### [Technical Problem]

Meanwhile, in recent years, a pattern formed on a surface of a substrate is densified, and there is a demand for performing an etching treatment with high accuracy. In addition, there is a demand for further efficiently performing the etching treatment of the substrate.

Therefore, the hafnia-containing film used as an etching mask is required to have higher etching resistance than in the related art.

The present invention has been made in view of the above-described circumstances, and an object of the present invention is to provide a hafnium compound-containing sol-gel liquid capable of forming a hafnia-containing film having particularly excellent etching resistance, and to provide a hafnia-containing film formed of the hafnium compound-containing sol-gel liquid.

### [Solution to Problem]

As a result of intensive studies by the present inventors in order to solve the above problems, the following findings were obtained.

In the hafnia-containing film, the etching resistance is improved by increasing the degree of crystallization. Since the one or two or more elements M selected from the group consisting of Zr, Ti, and Nb have a crystallization temperature lower than that of Hf, by containing an appropriate amount of the element M in the hafnium compound-containing sol-gel liquid, the element M is rapidly crystallized to form a seed crystal, crystallization of Hf is promoted, and a hafnia-containing film having a high degree of crystallization and excellent etching resistance can be formed.

The present invention has been made based on the above-described knowledge, and a hafnium compound-containing sol-gel liquid is a hafnium compound-containing sol-gel liquid containing an alcohol that serves as a solvent and a hafnium compound that serves as a hafnia source, in which the hafnium compound-containing sol-gel liquid contains one or two or more elements M selected from a group consisting of Zr, Ti, and Nb, and a mass ratio W_{M}/W_{Hf} of a content W_{M} of the elements M to a content W_{Hf} of Hf as a metal component is within a range of 0.2% or more and 5.0% or less.

Since the hafnium compound-containing sol-gel liquid having the configuration contains, together with Hf, one or two or more elements M selected from the group consisting of Zr, Ti, and Nb, and the mass ratio W_{M}/W_{Hf} of a content W_{M} of the elements M to a content W_{Hf} of Hf as a metal component is set within a range of 0.2% or more and 5.0% or less, the one or two or more elements M selected from the group consisting of Zr, Ti, and Nb are crystallized to form a seed crystal, and the crystallization of Hf is promoted. Therefore, by drying and sintering the hafnium compound-containing sol-gel liquid, it is possible to form a hafnia-containing film having a high degree of crystallization and excellent etching resistance.

Here, in the hafnium compound-containing sol-gel liquid according to the embodiment of the present invention, the alcohol that serves as a solvent is preferably a lower alcohol having 5 or less carbon atoms.

In this case, since the low alcohol having 5 or less carbon atoms is used as the solvent, the solvent can be relatively easily evaporated, and the hafnia-containing film can be stably formed.

In addition, in the hafnium compound-containing sol-gel liquid according to the embodiment of the present invention, a content of the hafnium compound is preferably set within a range of 0.05 wt% or more and 10 wt% or less.

In this case, since the content of the hafnium compound is set within the above-described range, by drying and sintering the hafnium compound-containing sol-gel liquid, a hafnia-containing film can be reliably formed.

Furthermore, the hafnium compound-containing sol-gel liquid according to the embodiment of the present invention preferably contains a polyalcohol having one or more ether groups in the molecule as a wettability improver.

The polyalcohol has a high affinity for a hydrophilic surface since the polyalcohol includes a plurality of hydroxyl groups (-OH groups) in the molecule, and also has a high affinity for the hafnium compound-containing sol-gel liquid since the polyalcohol has an ether group (-O-) in the molecule. Therefore, in a case where the hafnium compound-containing sol-gel liquid contains the polyalcohol, it is possible to uniformly apply the hafnium compound-containing sol-gel liquid onto the hydrophilic surface of the substrate.

In addition, in the hafnium compound-containing sol-gel liquid according to the embodiment of the present invention, a content of the polyalcohol is preferably set within a range of 0.05 wt% or more and 20 wt% or less.

In this case, since the content of the polyalcohol is set within the above-mentioned range, the hafnium compound-containing sol-gel liquid can be further uniformly applied onto the hydrophilic surface of the substrate.

In addition, the hafnium compound-containing sol-gel liquid according to the embodiment of the present invention preferably further contains a stabilizer.

In this case, since the stabilizer is contained, deterioration of the hafnium compound-containing sol-gel liquid can be suppressed, and handling is improved.

A hafnia-containing film according to the embodiment of the present invention contains hafnia (HfO₂) and one or two or more elements M selected from a group consisting of Zr, Ti, and Nb, in which a mass ratio W_{M}/W_{HfO2} of a content W_{M} of the elements M to a content W_{HfO2} of the HfO₂ is within a range of 0.05% or more and 5.0% or less.

According to the hafnia-containing film having the configuration, since the mass ratio W_{M}/W_{HfO2} of a content W_{M} of one or two or more elements M selected from the group consisting of Zr, Ti, and Nb to a content W_{HfO2} of the HfO₂ is set within a range of 0.05% or more and 5.0% or less, crystallization is promoted by the one or two or more the elements M selected from the group consisting of Zr, Ti, and Nb, and the degree of crystallization is high and the etching resistance is excellent.

### [Advantageous Effects of Invention]

According to the present invention, it is possible to provide a hafnium compound-containing sol-gel liquid capable of forming a hafnia-containing film having particularly excellent etching resistance, and a hafnia-containing film formed of the hafnium compound-containing sol-gel liquid.

### [Brief Description of Drawings]

FIG. 1 is a flowchart showing a method for producing a hafnium compound-containing sol-gel liquid according to one embodiment of the present invention.
FIG. 2 is a flowchart showing a method for producing a hafnia-containing film according to one embodiment of the present invention.

### [Description of Embodiments]

Hereinafter, a hafnium compound-containing sol-gel liquid and a hafnia-containing film, which are embodiments of the present invention, will be described.

The hafnium compound-containing sol-gel liquid according to the present embodiment contains an alcohol that serves as a solvent and a hafnium compound that serves as a hafnia source.

The hafnium compound-containing sol-gel liquid according to the present embodiment includes one or two or more elements M selected from the group consisting of Zr, Ti, and Nb as a metal component, and the mass ratio W_{M}/W_{Hf} of the content W_{M} of the one or two or more elements M selected from the group consisting of Zr, Ti, and Nb to the content W_{Hf} of Hf is within a range of 0.2% or more and 5.0% or less.

The mass ratio W_{M}/W_{Hf} is preferably 0.25% or more, and more preferably 0.3% or more. On the other hand, the mass ratio W_{M}/W_{Hf} is preferably 1.0% or less and more preferably 0.5% or less.

In addition, the hafnium compound-containing sol-gel liquid according to the present embodiment may contain a polyalcohol having one or more ether groups in the molecule as a wettability improver in addition to the solvent and the hafnium compound.

The polyalcohol is not particularly limited as long as it may contain three or less ether groups in the molecule.

Furthermore, the hafnium compound-containing sol-gel liquid according to the present embodiment may contain a stabilizer.

In the hafnium compound-containing sol-gel liquid according to the present embodiment, a content of the hafnium compound that serves as a hafnia source is preferably within a range of 0.05 wt% or more and 10 wt% or less.

The content of hafnium is not particularly limited, and may be within a range of 0.07 wt% or more and 1.0 wt% or less, or may be within a range of 0.1 wt% or more and 0.5 wt% or less.

In addition, in a case of containing the polyalcohol as the wettability improver, the content of the polyalcohol is preferably within a range of 0.05 wt% or more and 20 wt% or less.

In a case of containing the stabilizer, a content of the stabilizer is preferably 20 wt% or less.

That is, in the composition of the hafnium compound-containing sol-gel liquid according to the present embodiment, it is preferable that the content of the hafnium compound is within a range of 0.05 wt% or more and 10 wt% or less, the content of the polyalcohol is within a range of 0 wt% or more and 20 wt% or less, the content of the stabilizer is within a range of 0 wt% or more and 20 wt% or less, and the balance is the solvent.

Here, as the alcohol that serves as a solvent, a lower alcohol having 5 or less carbon atoms is preferably used. The lower alcohol is an alcohol in which in a molecule, the number of carbon atoms is 5 or less and the number of hydroxyl groups (-OH groups) is 2 or less.

Examples of the lower alcohol include monohydric alcohols such as methanol, ethanol, n-propanol, isopropanol, n-butanol, sec-butanol, isobutyl alcohol, tert-butyl alcohol, n-pentanol, 2-pentanol, 3-pentanol, 2-methyl-1-butanol, isopentyl alcohol, tertpentyl alcohol, 3-methyl-2-butanol, and neopentyl alcohol, and dihydric alcohols such as ethylene glycol, propylene glycol, trimethylene glycol, 1,2-butanediol, 1,3-butanediol, and 1,4-butanediol.

In the present embodiment, as a solvent, propanol or butanol, which is the lower alcohol, is preferably used.

Examples of the hafnium compound that serves as the hafnia source include a hafnium compound selected from the group consisting of a hafnium halide, a hafnium halous acid salt, a hafnium hypohalogenous acid salt, a hafnium halogen acid salt, a hafnium perhalogen acid salt, a hafnium inorganic acid salt, a hafnium organic acid salt, a hafnium alkoxide, and a hafnium complex.

In the present embodiment, as the hafnium compound that serves as a hafnia source, a hafnium alkoxide having 5 or less carbon atoms is preferably used, and specifically, hafnium (IV) methoxide, hafnium (IV) ethoxide, hafnium (IV) propoxide, hafnium butoxide, hafnium(IV) n-butoxide, hafnium(IV) t-butoxide, hafnium(IV) pentoxide, hafnium(IV) isopropoxide monoisopropylate, and the like are preferably used.

The element M (one or two or more elements selected from the group consisting of Zr, Ti, and Nb) is contained as a compound, and is contained as a compound of the element M, which is selected from the group consisting of a halide, a halite, a hypohalite, a halate, a perhalate, an inorganic acid salt, an organic acid salt, an alkoxide, and a complex of the element M. As the compound of the element M, an alkoxide having 5 or less carbon atoms is preferably used.

By drying and sintering the hafnium compound-containing sol-gel liquid containing these hafnium compounds that serves as the hafnia source, hafnia (HfO₂) is formed and a hafnia-containing film is formed.

As the polyalcohol having one or more ether groups in the molecule, which serves as wettability improver, for example, diethylene glycol, triethylene glycol, tetraethylene glycol, diglycerol, dipentaerythritol, or the like is preferably used.

The polyalcohol having one or more ether groups in the molecule has a high affinity for a hydrophilic surface since the polyalcohol includes a plurality of hydroxyl groups (-OH groups) in the molecule, and also has a high affinity for the hafnium compound-containing sol-gel liquid since the polyalcohol has an ether group (-O-) in the molecule. Therefore, the hafnium compound-containing sol-gel liquid containing such a polyalcohol can be uniformly applied to the hydrophilic surface of the substrate.

Here, in a case where the content of the polyalcohol having one or more ether groups in a molecule in the hafnium compound-containing sol-gel liquid is set within a range of 0.05 wt% or more and 20 wt% or less, the wettability can be sufficiently improved and the hafnium compound-containing sol-gel liquid can be uniformly applied onto the hydrophilic surface of the substrate.

The lower limit of the content of the polyalcohol having one or more ether groups in the molecule is more preferably 0.1 wt% or more and still more preferably 0.2 wt% or more. On the other hand, the upper limit of the content of the polyalcohol having one or more ether groups in the molecule is more preferably 10 wt% or less and still more preferably 5 wt% or less.

As the stabilizer, for example, acetylacetone, ethyl acetoacetate, acetoin, hydroxyacetone, malonic acid, acetic acid, acetic acid anhydride, lactic acid, oxalic acid, citric acid, tartaric acid, triethanolamine, diethanolamine, or the like is preferably used.

By adding a stabilizer to the hafnium compound-containing sol-gel liquid, deterioration of the hafnium compound-containing sol-gel liquid can be suppressed, and handleability of the hafnium compound-containing sol-gel solution can be improved. Therefore, a stabilizer may be appropriately added as necessary.

Here, the content of the stabilizer in the hafnium compound-containing sol-gel liquid is preferably regulated within a range of 0 wt% or more and 10 wt% or less.

The lower limit of the content of the stabilizer is more preferably 0.05 wt% or more and still more preferably 0.1 wt% or more. On the other hand, the upper limit of the stabilizer is more preferably 8 wt% or less and still more preferably 5 wt% or less.

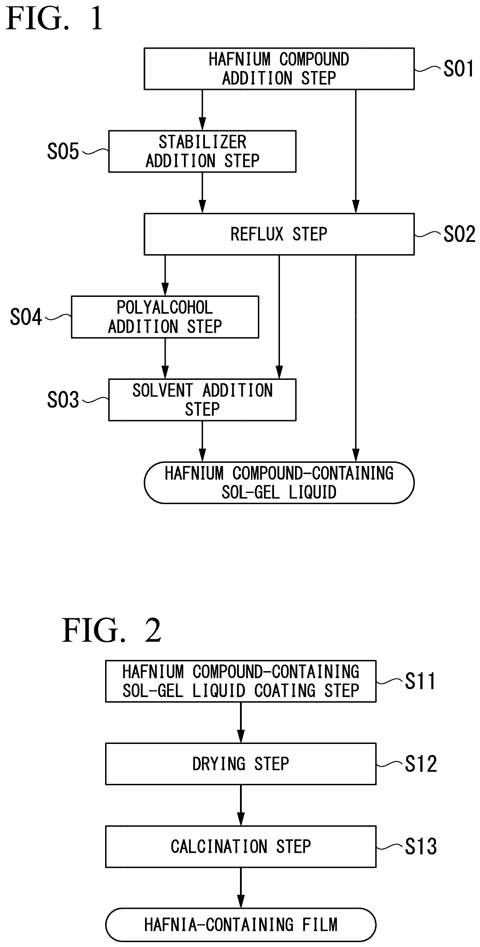

Next, the method for producing the hafnium compound-containing sol-gel liquid according to the present embodiment mentioned above is described with reference to a flowchart of FIG. 1.

The method for producing the hafnium compound-containing sol-gel liquid according to the present embodiment includes, as shown in FIG. 1, a hafnium compound addition step S01 of adding the hafnium compound to an alcohol that serves as a solvent, and a reflux step S02 of refluxing the solvent to which the hafnium compound that serves as a hafnia source has been added. In order to adjust the composition, a solvent addition step S03 may be provided.

In addition, in a case of adding a polyalcohol that serves as a wetting improver, a polyalcohol addition step S04 is provided. Furthermore, in a case of adding the stabilizer, the stabilizer addition step S05 is provided.

In the hafnium compound addition step S01, the hafnium compound is added to the solvent in a state where the alcohol that serves as the solvent is heated and stirred.

Here, a compound of an element M is, as a metal component, further added thereto such that a mass ratio W_{M}/W_{Hf} of a content W_{M} of one or more elements M selected from the group consisting of Zr, Ti, and Nb to a content W_{Hf} of Hf is in a range of 0.2% or more and 5.0% or less. Examples of the compound of the element M include a compound of the element M selected from the group consisting of a halide, a halite, a hypohalite, a halate, a perhalate, an inorganic acid salt, an organic acid salt, an alkoxide, and a complex of the element M. As the compound of the element M, an alkoxide having 5 or less carbon atoms is preferably used.

The atmosphere in a case of adding is preferably a non-oxidizing atmosphere, and is regulated to a nitrogen atmosphere in the present embodiment.

In addition, it is preferable that a temperature of the alcohol at the time of adding the hafnium compound and the compound of the element M is within a range of 5°C or more and 40°C or less.

In the reflux step S02, the solvent to which the hafnium compound and the compound of the element M have been added is heated with stirring to perform a reflux treatment.

It is preferable that a heating temperature in the reflux step S02 is within a range of 80°C or more and 200°C or less. In addition, the holding time at the heating temperature is preferably within a range of 0.5 hours or more and 5 hours or less.

In a case where a stabilizer is added, the stabilizer addition step S05 is preferably carried out before the reflux step S02.

In addition, in a case of adding the polyalcohol, it is preferable to perform a polyalcohol addition step S04 after the reflux step S02.

In the polyalcohol addition step S04, the solvent used in the reflux step S02 is cooled to room temperature (for example, within a range of 20°C or more and 30°C or less), and the polyalcohol having one or more ether groups in the molecule is added thereto and mixed with stirring.

In the solvent addition step S03, in order to adjust the composition of the hafnium compound-containing sol-gel liquid, an alcohol that serves as a solvent is added thereto.

By each of the above-described steps, the hafnium compound-containing sol-gel liquid according to the present embodiment is manufactured.

The hafnia-containing film according to the present embodiment is formed of the above-described hafnium compound-containing sol-gel liquid according to the present embodiment.

A hafnia-containing film according to the present embodiment contains hafnia (HfO₂) and one or two or more elements M selected from the group consisting of Zr, Ti, and Nb, in which a mass ratio W_{M}/W_{HfO2} of a content W_{M} of the elements M to a content W_{HfO2} of the HfO₂ is within a range of 0.05% or more and 5.0% or less.

The mass ratio W_{M}/W_{HfO2} may be 0.10% or more and 5.0% or less, may be 0.05% or more and 3.26% or less, or may be 0.10 or more and 3.26% or less.

The hafnium content in the hafnia-containing film may be 95.00% by mass or more and 99.95% by mass or less, may be 95.0% by mass or more and 99.90% by mass or less, may be 96.74% by mass or more and 99.95% by mass or less, or may be 96.74% by mass or more and 99.90% by mass or less.

The range of the content of the element M in the hafnia-containing film is determined from the hafnium content and the mass ratio W_{M}/W_{HfO2}.

Next, the method for producing the hafnia-containing film according to the present embodiment will be described with reference to the flowchart of FIG. 2.

The method for producing a hafnia-containing film according to the present embodiment, as shown in FIG. 2, includes a hafnium compound-containing sol-gel liquid coating step S11 of applying the hafnium compound-containing sol-gel liquid according to the present embodiment onto a surface of a substrate, a drying step S12 of drying the applied hafnium compound-containing sol-gel liquid to form a hafnium compound-containing gel film, and a sintering step S13 of sintering the hafnium compound-containing gel film to form a hafnia-containing film.

Here, in the present embodiment, the substrate on which the hafnia-containing film is formed is a metal substrate, but is not limited to a metal. It is preferable that a hydrophilic film such as an oxide film is formed on the surface of the substrate.

In addition, roughness may be formed on the surface of the substrate by a blast treatment, an etching treatment, or the like.

As the substrate, single metals such as aluminum, titanium, iron, nickel, zinc, magnesium, and copper, alloys thereof, or oxides thereof, element semiconductors such as silicon and gallium, or compound semiconductors such as silicon oxide, silicon nitride, silicon carbide, indium phosphide, gallium nitride, gallium arsenic, and gallium oxide can be used.

In the hafnium compound-containing sol-gel liquid coating step S11, the hafnium compound-containing sol-gel liquid according to the present embodiment is applied onto the surface of the substrate. At this time, the coating method is not particularly limited, and a spray method, a dip method, or the like may be used, but in the present embodiment, the hafnium compound-containing sol-gel liquid is applied by spin coating.

Here, in a case where the hafnium compound-containing sol-gel liquid according to the present embodiment contains a polyalcohol having one or more ether groups in a molecule as the wetting improver, the hafnium compound-containing sol-gel liquid can be uniformly applied to the hydrophilic surface of the substrate.

In the drying step S12, the hafnium compound-containing sol-gel liquid applied onto the surface of the substrate is dried to form a hafnium compound-containing gel film. Here, in a case where, in the hafnium compound-containing sol-gel liquid according to the present embodiment, a lower alcohol having 5 or less carbon atoms is used as a solvent, the solvent can be relatively easily evaporated by the drying step S12.

As the heating conditions in the drying step S12 are, in the air or an oxygen atmosphere, the heating temperature is regulated within a range of 100°C or more and 400°C or less, and the holding time at the heating temperature is regulated within a range of 0.5 minutes or more and 10 minutes or less are preferable.

By repeatedly performing the hafnium compound-containing sol-gel liquid coating step S11 and the drying step S12, a hafnium compound-containing gel film having a predetermined thickness may be formed.

In the sintering step S13, the hafnium compound-containing gel film is heated and sintered to form a hafnia-containing film.

As the heating conditions in the sintering step S13 are, in the air or an oxygen atmosphere, the heating temperature is regulated within a range of 400°C or more and 1,000°C or less, and the holding time at the heating temperature is regulated within a range of 0.5 minutes or more and 10 minutes or less are preferable.

In a case where the hafnium compound-containing sol-gel liquid coating step S11 and the drying step S12 are repeatedly performed, the sintering step S13 may be performed after each drying step S12.

By each of the above-described steps, the hafnia-containing film according to the present embodiment is formed on the surface of the substrate.

According to the hafnium compound-containing sol-gel liquid according to the present embodiment having the above-described configuration, since the hafnium compound that serves as a hafnia source is contained and the mass ratio W_{M}/W_{Hf} of the content W_{M} of the element M to the content W_{Hf} of Hf is within a range of 0.2% or more and 5.0% or less as a metal component, one or two or more the elements M selected from the group consisting of Zr, Ti, and Nb are crystallized to form a seed crystal, and crystallization of Hf is promoted, thereby a hafnia-containing film having a high degree of crystallization and excellent etching resistance can be formed.

In a case where, in the hafnium compound-containing sol-gel liquid according to the present embodiment, the alcohol that serves as a solvent is the lower alcohol having 5 or less carbon atoms, in the drying step S12, the solvent can be relatively easily evaporated, thereby the hafnia-containing film can be stably formed.

In a case where, in the hafnium compound-containing sol-gel liquid according to the present embodiment, the content of the hafnium compound is within a range of 0.05 wt% or more and 10 wt% or less, a hafnia-containing film can be reliably formed.

In a case where the hafnium compound-containing sol-gel liquid according to the present embodiment contains the polyalcohol having one or more ether groups in the molecule as a wettability improver, since the polyalcohol has high affinity for a hydrophilic surface and high affinity for the hafnium compound-containing sol-gel liquid, the hafnium compound-containing sol-gel liquid can be uniformly applied to the hydrophilic surface of the substrate.

In a case where, in the sol-gel solution containing a hafnium compound according to the present embodiment, the content of the polyalcohol is set to be within a range of 0.05 wt% or more and 20 wt% or less, the hafnium compound-containing sol-gel liquid can be more uniformly applied to the hydrophilic substrate surface.

In a case where a stabilizer is further contained in the hafnium compound-containing sol-gel liquid of the present embodiment, deterioration of the hafnium compound-containing sol-gel solution can be suppressed, and the hafnium compound-containing sol-gel solution can be easily handled.

Since the hafnia-containing film according to the present embodiment contains hafnia (HfO₂) and contains one or two or more elements M selected from the group consisting of Zr, Ti, and Nb, and the mass ratio W_{M}/W_{HfO2} of a content W_{M} of one or two or more elements M selected from the group consisting of Zr, Ti, and Nb to a content W_{HfO2} of the HfO₂ is set within a range of 0.05% or more and 5.0% or less, crystallization is promoted by the one or two or more the elements M selected from the group consisting of Zr, Ti, and Nb, and the degree of crystallization is high and the etching resistance is excellent.

Although the embodiments of the present invention are described above, the present invention is not limited thereto, and can be appropriately modified without departing from the technical idea of the invention.

### [Examples]

Results of a verification experiment conducted to verify the effectiveness of the present invention will be described below.

A hafnium butoxide was used as a hafnium raw material, 1-butanol was used as a solvent, and acetylacetone was used as a stabilizer. In addition, Zr, Ti, and Nb were added in proportions shown in Table 1 using zirconium butoxide, titanium isopropoxide, and niobium ethoxide. These were mixed and refluxed for 1 hour, and then filtered through a filter to synthesize a hafnium compound-containing sol-gel liquid. Acetylacetone was used as a stabilizer, and diethylene glycol was used as a wettability improver.

The obtained hafnium compound-containing sol-gel liquid was added dropwise onto a silicon base plate and applied by spin coating.

The silicon base plate on which the hafnium compound-containing sol-gel liquid had been applied was heated to 100°C to 250°C using a hot plate, and then loaded into a muffle furnace at 600°C and heated for 5 minutes to form a hafnia-containing film.

The hafnium compound-containing sol-gel liquid and the hafnia-containing film of Examples and Comparative Examples of the present invention were evaluated as follows.

### (Zr, Ti, and Nb in hafnium compound-containing sol-gel liquid)

1 g of the hafnium compound-containing sol-gel liquid was taken, and put into a mixed solution of 60 wt% nitric acid (2.5 mL) and 50 wt% hydrofluoric acid (2.5 mL).

The mixed solution was heated. The heated mixed solution was diluted with ultrapure water to 50 mL, the contents of Hf, Zr, Ti, and Nb were measured using ICP-OES, and a content ratio of Zr, Ti, and Nb in a case where the content of Hf was 100 wt% was calculated.

### (Zr, Ti, and Nb in hafnia-containing film)

The silicon base plate on which the hafnia-containing film had been formed was immersed in 1 wt% hydrofluoric acid, heating was continued until the hafnia-containing film was dissolved, and then the silicon base plate was taken out to prepare a measurement solution.

The measurement solution was appropriately diluted, and the eluted amounts of Hf, Zr, Ti, and Nb were determined by ICP-OES.

After conversion assuming that all Hf's were HfO₂, a content ratio of Zr, Ti, and Nb with respect to HfO₂ was obtained.

### (Etching rate)

The silicon base plate (20 mm × 20 mm) on which the hafnia-containing film had been formed and the film thickness of the hafnia-containing film had been measured in advance, was immersed in the 1 wt% HF solution (200 mL) at 25°C while stirring. A film thickness after the immersion for a certain time was measured, and an etching rate was calculated from the change in film thickness before and after the immersion. The film thickness of the hafnia-containing film was measured using an ellipsometer (UVISEL-HR320 AGMS manufactured by HORIBA, Ltd.). The measurement was performed at three locations, and the average value thereof was defined as the film thickness.

A case where the etching rate was 2 nm/min or less was evaluated as "A", and a case where the etching rate exceeded 2 nm/min was evaluated as "B".

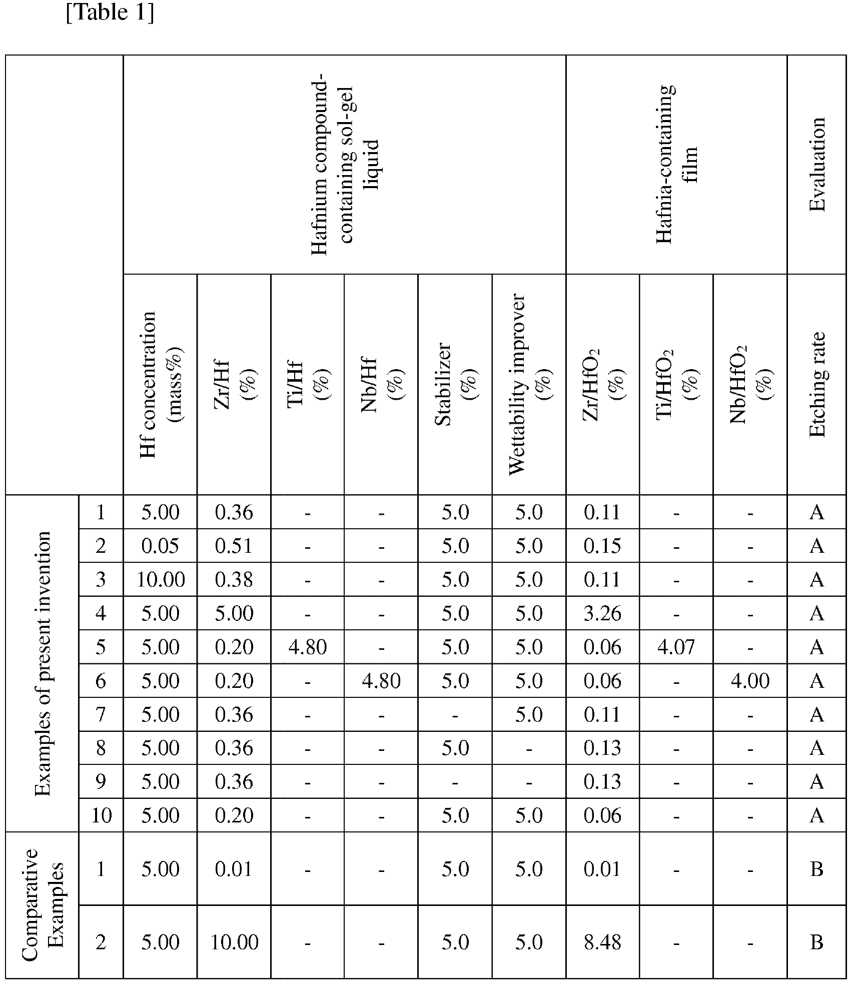

In Comparative Example 1, the mass ratio W_{M}/W_{Hf} of the content W_{M} of one or two or more elements M selected from the group consisting of Zr, Ti, and Nb to the content W_{Hf} of Hf was set to 0.01 %, and the evaluation of the etching rate was "B". It is presumed that this is because the content of the element M was small and the crystallization of the hafnia-containing film was not promoted.

In Comparative Example 2, the mass ratio W_{M}/W_{Hf} of the content W_{M} of one or two or more elements M selected from the group consisting of Zr, Ti, and Nb to the content W_{Hf} of Hf was 10%, and the evaluation of the etching rate was "B". It is presumed that this is because the content of the element M was large, the portion where the element M of the hafnia-containing film was present was locally etched, and the film thickness of the hafnia-containing film is reduced.

On the other hand, in Examples 1 to 10 of the present invention, the mass ratio W_{M}/W_{Hf} of the content W_{M} of one or two or more elements M selected from the group consisting of Zr, Ti, and Nb to the content W_{Hf} of Hf is set to be within a range of 0.2% or more and 5.0% or less, and the mass ratio W_{M}/W_{HfO2} of the content W_{M} of one or two or more elements M selected from the group consisting of Zr, Ti, and Nb to the content W_{HfO2} of HfO₂ is set to be within a range of 0.05% or more and 5.0% or less in the formed hafnia-containing film. In addition, the evaluation of the etching rate for the formed hafnia-containing film was "A". It is presumed that this is because the crystallization of the hafnia-containing film is sufficiently promoted by the element M.

From the above, according to examples of the present invention, it was confirmed that it is possible to provide a hafnium compound-containing sol-gel liquid capable of forming a hafnia-containing film having particularly excellent etching resistance, and a hafnia-containing film formed of the hafnium compound-containing sol-gel liquid.

### [Industrial Applicability]

It is possible to provide a hafnium compound-containing sol-gel liquid capable of forming a hafnia-containing film having particularly excellent etching resistance, and a hafnia-containing film formed of the hafnium compound-containing sol-gel liquid.

## Claims

1. A hafnium compound-containing sol-gel liquid comprising:
an alcohol as a solvent; and
a hafnium compound as a hafnia source,
wherein the hafnium compound-containing sol-gel liquid contains one or two or more elements M selected from a group consisting of Zr, Ti, and Nb,
a mass ratio W_{M}/W_{Hf} of a content W_{M} of the elements M to a content W_{Hf} of Hf as a metal component is within a range of 0.2% or more and 5.0% or less.

2. The hafnium compound-containing sol-gel liquid according to Claim 1,
wherein the alcohol as a solvent is a lower alcohol having 5 or less carbon atoms.

3. The hafnium compound-containing sol-gel liquid according to Claim 1 or 2,
wherein a content of the hafnium compound is within a range of 0.05 wt% or more and 10 wt% or less.

4. The hafnium compound-containing sol-gel liquid according to any one of Claims 1 to 3, further comprising:
a polyalcohol having one or more ether groups in a molecule as a wettability improver.

5. The hafnium compound-containing sol-gel liquid according to Claim 4,
wherein a content of the polyalcohol is within a range of 0.05 wt% or more and 20 wt% or less.

6. The hafnium compound-containing sol-gel liquid according to any one of Claims 1 to 5, further comprising:
a stabilizer.

7. A hafnia-containing film comprising:
hafnia (HfO₂); and
one or two or more elements M selected from a group consisting of Zr, Ti, and Nb,
wherein a mass ratio W_{M}/W_{HfO2} of a content W_{M} of the elements M to a content W_{HfO2} of the HfO₂ is within a range of 0.05% or more and 5.0% or less.
